# EUROPÄISCHE PATENTANMELDUNG

(11) **EP 1 496 732 A2**
(43) Veröffentlichungstag der Anmeldung: **12.01.2005**
(21) Anmeldenummer: 04015924.6
(22) Anmeldetag: 07.07.2004
(51) Int. Cl.: H05K 3/28, H05K 3/00, H05K 5/00

(54) **Gehäuse für elektrische oder elektronische Vorrichtungen**

(30) Priorität: 07.07.2003 DE 10330789
(71) Anmelder: Carl Freudenberg KG, 69469 Weinheim (DE); Erwin Quarder Werkzeugbau GmbH, 32339 Espelkamp (DE)
(72) Erfinder: Schäfer, Peter, 64297 Darmstadt-Eberstadt (DE); Röhl, Thomas, 67269 Grünstadt (DE); Quarder, Martin, 32425 Minden (DE)

(57) **Zusammenfassung**

Gehäuse für elektrische oder elektronische Vorrichtungen mit einer Wandung, in die zumindest eine mit elektronischen Bauteilen bestückte Leiterbahn eingebettet ist, dadurch gekennzeichnet, dass die Leiterbahn durch einen flexiblen Träger 2 gebildet ist, der wenigstens auf einer Seite mit den elektronischen Bauteilen 3, 7 bestückt ist, wobei die Oberfläche 5 des Trägers 2 zumindest in einem Teilbereich des Gehäuses 10 zugleich die Oberfläche 6 der Innenwandung 4 des Gehäuses 10 bildet.

## Beschreibung

### Technisches Gebiet

Die Erfindung befasst sich mit einem Gehäuse für elektrische oder elektronische Vorrichtungen mit einer Wandung, an der zumindest ein flexibler Träger mit einer Leiterbahn angeordnet ist.

Derartige Gehäuse werden häufig aus Kunststoff hergestellt und dienen zum Schutz oder als Träger für die Leiterbahn bzw. die daran angebrachten elektronischen Bauteile. Da die elektrischen Geräte insbesondere solche, die in Kraftfahrzeugen eingesetzt werden, schwierigen Umgebungsbedingungen standhalten müssen, werden die elektronischen Bauteile mit Kunststoff umgossen. Nach anderen Verfahren werden beispielsweise flexible Leiterbahnen vor mechanischen Beschädigungen oder vor Oxidation dadurch geschützt, dass man sie mit einem thermoplastischen Material hinterspritzt.

### Stand der Technik

Aus der DE 100 32 849 C2 ist ein elektrisches Gerät bekannt, bei dem eine flexible Leiterbahn in die Gehäusewand eingebettet ist. Die elektronischen Bauteile befinden sich außerhalb der Gehäusewand. Die Verbindung zu diesen elektronischen Bauteilen wird über Kontaktelemente hergestellt die bündig mit der Oberfläche der Gehäusewand abschließen. Geräte dieser Art sind einfach herzustellen und vielseitig anwendbar.

Das Verfahren zur Herstellung eines elektrischen Gerätes mit einer in die Wand eingebetteten Leiterbahn ist in der DE 196 09 253 C2 beschrieben. Dabei handelt es sich um einen blanken Leiter der in den Formraum einer Werkzeugform eingelegt und dort vor Beginn des Einspritzvorgangs an einem oder mehreren voneinander beabstandeten Punkten mechanisch vorfixiert wird, und zwar derart, dass beim Einspritzen des Kunststoffteils der Leiter vom eingespritzten Material ummantelt wird.

Durch die DE 199 44 383 A1 ist desweiteren bekannt, an ausgewählten Stellen auf der Oberfläche elektrische Leiterbahnen mit an vorbestimmten Stellen angebrachten Kontaktstiften anzubringen und die Leiterbahnen mit einer Schicht aus thermoplastischem Kunststoff zu bedecken. Dabei wird so vorgegangen, dass zunächst ein Formteil/Rohling geformt wird, sodann vorgefertigte Leiterbahnen auf den Rohling aufgetragen werden und die Leiterbahnen mit einer Schicht aus einem thermoplastischen Kunststoff versiegelt werden. Die elektronischen Bauteile werden beim Versiegeln der Leiterbahn ebenfalls mit dem thermoplastischen Kunststoff bedeckt.

Mit der vorgenannten Erfindung soll eine Verbesserung der Ausbildung eines Kunststofformteils erreicht werden, das auf einer Seite auf seiner Oberfläche elektrische Leiterbahnen aufweist. Ein solches Kunstsofformteil ist in der DE 199 37 865 A1 beschrieben.

### Darstellung der Erfindung

Der Erfindung liegt die Aufgabe zugrunde, ein vereinfachtes Verfahren für die Herstellung eines Gehäuses für elektrische oder elektronische Vorrichtungen, sowie ein konstruktiv einfach aufgebautes Gehäuse für diesen Zweck zu schaffen. Das Gehäuse soll leicht herstellbar und sicher in seiner Anwendung sein.

Die Lösung der gestellten Aufgabe erfolgt mit den Merkmalen der Ansprüche 1 bzw. 8. Die Unteransprüche 2 bis 7 bzw. 9 bis 11 stellen bevorzugte Detailausbildungen gemäß den Ansprüchen 1 bzw. 8 dar.

Bei dem neuen Gehäuse wird ein flexibler Träger mit einer Leiterbahn gebildet, der vor seiner Anbringung am Gehäuse wenigstens auf einer Seite mit elektronischen Bauteilen bestückt ist und dessen Oberfläche zumindest in einem Teilbereich zugleich die Oberfläche der Innenwandung des Gehäuses bildet. Bei einem Gehäuse, bei dem der Träger mit den darin eingeschlossenen Leiterbahnen und angebrachten elektronischen Bauteilen einen relativ großen Anteil der Gehäusewandung bildet, ist dieses besonders günstig. Der flexible Träger mit den elektronischen Bauteilen wird separat vorgefertigt. Dabei bestehen verschiedene Möglichkeiten. Ganz generell hat der Träger eine Dicke von 40 bis 250 µm. Bei einem Träger, bei dem die Leiterbahnen in ein Polyimid eingebettet sind, wird eine Dicke von 40 bis 250 µm bevorzugt.

Bei der Ausbildung des Gehäuses wird eine Gehäusewandung mit einer Dicke von 0,5 bis 4 mm, vorzugsweise von 1,0 bis 2,5 mm bevorzugt.

Der Träger kann sowohl nur auf einer Seite mit elektronischen Bauteilen versehen werden als auch beidseitig. Bei der Einbettung des Trägers in die Wandung des Gehäuses werden die innenliegenden elektronischen Bauteile von dem Werkstoff der Wandung mit umschlossen. Es ist günstig, wenn auf dieser Seite die sensibleren Bauteile angebracht werden, die durch die Wandung dann voll geschützt sind.

Das Verfahren zur Herstellung des Gehäuses zeichnet sich dadurch aus, dass auf die Wandung eines geöffneten Spritzwerkzeugs für Kunststoffe ein mit elektronischen Bauteilen bestückter flexibler Träger aufgelegt, das Werkzeug geschlossen wird und ein verflüssigter Kunststoff gegen die in das Werkzeuginnere gerichtete Oberfläche des Trägers gespritzt wird, so daß der Träger nach Verfestigung des Kunststoffes an der Oberfläche der Gehäusewandung fixiert ist, wonach das Gehäuse aus dem Formraum des Werkzeugs entnommen wird. Gegebenenfalls kann der Träger zu Beginn des Spritzvorgangs durch zumindest einen Niederhalter an die Innenwandung des Werkzeugs angedrückt werden. Der Niederhalter wird sodann während des Spritzvorgangs von dem Träger abgehoben.

Mit der Erfindung können sehr unterschiedliche Gehäuse mit daran angebrachten flexiblen Trägern hergestellt werden.

### Kurzbeschreibung der Zeichnungen

Anhand der in der Zeichnung dargestellten Ausführungsbeispiele wird die Erfindung prinzipiell näher erläutert.

### Es zeigt:

- Fig. 1:: einen Ausschnitt aus einer Gehäusewandung mit einem daran angebrachten Träger, an dem einseitig elektronische Bauteile angebracht sind.

- Fig. 2:: ein Wandungsabschnitt mit einem Träger mit beidseitig angebrachten Bauteilen und
- Fig. 3: eine Draufsicht auf die Innenwandung eines Gehäuses mit daran angebrachtem Träger

### Ausführung der Erfindung

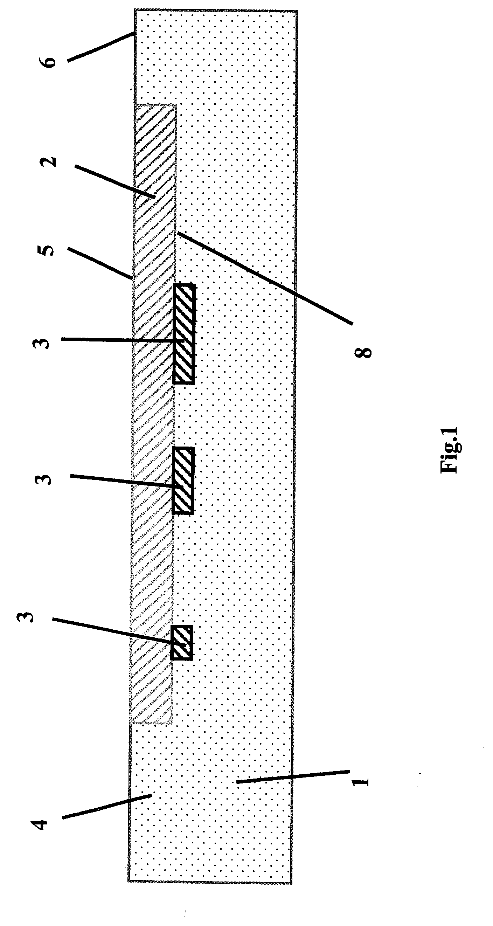

In der Figur 1 ist ein Ausschnitt aus einer Gehäusewandung 1 gezeigt, an die ein flexibler Träger 2 angefügt ist. Der Träger 2 enthält eine Leiterbahn und ist mit den elektronischen Bauteilen 3 bestückt.. In dem gezeigten Beispiel sind die Bauteile 3 nur auf der innen liegenden Seite des Trägers 2 angeordnet. Der Träger 2 ist derart in die Innenwandung 4 des nicht näher gezeigten Gehäuses integriert, dass seine Oberfläche 5 bündig mit der Oberfläche 6 der Innenwandung 4 des Gehäuses 10 verläuft. Auf diese Weise stellt der Träger 2 einen Teil der Oberfläche 6 der Innenwandung 4 dar. Auf der Figur ist die Wandung 1 mit dem Träger 2 erheblich vergrößert dargestellt. In der praktischen Ausführung beträgt die Dicke der Gehäusewandung 1 wenige mm und die Dicke des Trägers 2 wenige µm. Die Gehäusewandung 1 besteht aus einem für Spritzgußverfahren verwendbarem Kunststoff.

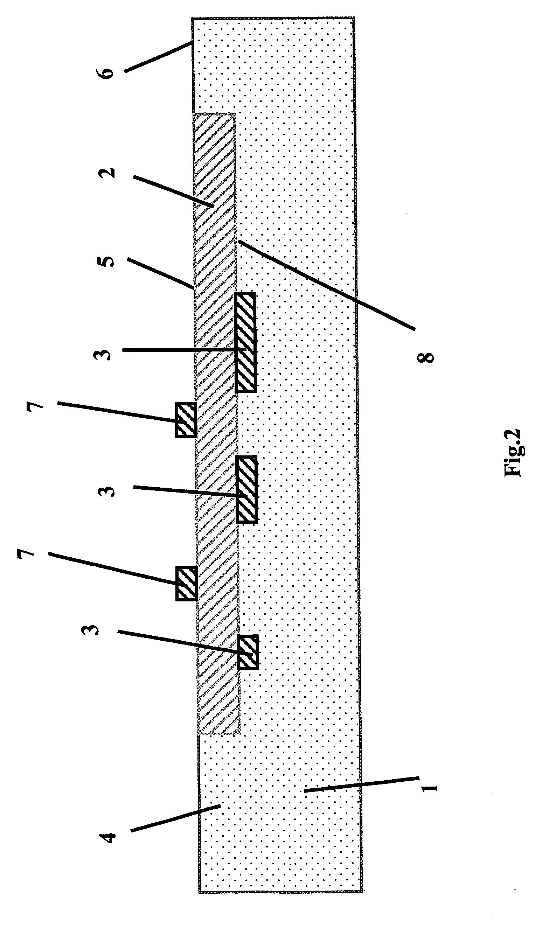

In der Figur 2 ist eine Ausführungsform gezeigt, bei der die Wandung 1 mit einem Träger 2 versehen ist, der beidseitig mit elektronischen Bauteilen 3 und 7 bestückt ist. Der prinzipielle Aufbau von Wandung 1 und Träger 2 wird beibehalten, so daß auch hier die Oberfläche 5 des Trägers 2 bündig mit der Oberfläche 6 der Innenwandung 4 verläuft. Als Material für den Träger 2 wird ein Polyimid verwendet.

Bei der Herstellung des neuen Gehäuses 10 wird der vorgefertigte Träger 2 mit den elektronischen Bauteilen 3 und 7 auf die Wandung eines geöffneten Spritzwerkzeugs aufgelegt. Bei einer Ausführung nach der Figur 1 ist die Wandung des Spritzwerkzeugs eben ausgeführt. Bei der Ausführungsform nach der Figur 2 sind in der oberen Wandung des Spritzwerkzeugs Aussparungen für die elektronischen Bauteile 7 eingearbeitet. Nach dem Einlegen des Trägers 2 in das Spritzwerkzeug wird dasselbe geschlossen und ein verflüssigter Kunststoff in das Werkzeuginnere eingespritzt. Dabei wird der Kunststoffstrahl so ausgerichtet, dass er gegen die zur späteren Wandung 1 gerichtete Oberfläche 8 des Trägers 2 gerichtet ist. Nach der Verfestigung des Kunststoffes ist der Träger 2 an der Oberfläche des Gehäuses 10 fixiert und das Gehäuse 10 kann aus dem Formraum des Werkzeugs entnommen werden. Gegebenenfalls können auch im Werkzeug an sich bekannte Niederhalter eingesetzt werden, welche den Träger 2 zu Beginn des Spritzvorgangs an die Werkzeugwandung andrücken. Diese Niederhalter werden während des Spritzvorgangs vom Träger 2 abgezogen, damit in der Wandung 1 keine Öffnungen verbleiben.

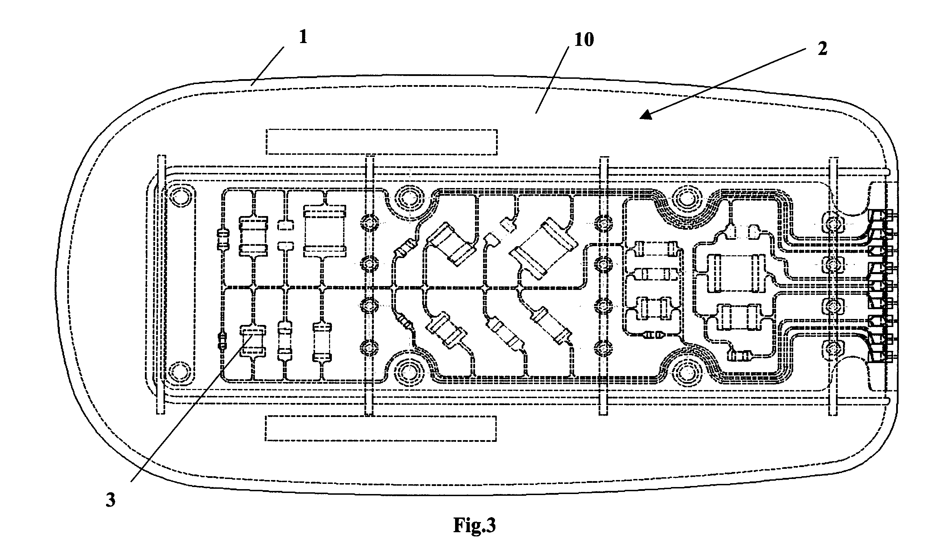

In der Figur 3 ist die Innenseite des Gehäuses 10 gezeigt, die mit dem flexiblen Träger 2 versehen ist. Der Träger 2 ist, wie in den Figuren 1 und 2 gezeigt, in die Oberfläche der Wandung 1 bündig eingefügt. Der Träger 2 ist mit den Bauteilen 3 versehen, die in der Wandung 1 integriert sind. Wie in der Figur 3 erkennbar, ist der Anteil des Trägers 2 an der Oberfläche der Innenwandung 4 relativ groß. Im gezeigten Beispiel beträgt er etwa 50 % der Oberfläche der Innenwandung 4.

## Patentansprüche

1. Gehäuse für elektrische oder elektronische Vorrichtungen mit einer Wandung, an der zumindest ein flexibler Träger mit einer Leiterbahn angeordnet ist, **dadurch gekennzeichnet, dass** der Träger (2) vor seiner Anbringung am Gehäuse wenigstens auf einer Seite mit den elektronischen Bauteilen (3, 7) bestückt ist, wobei die Oberfläche (5) des Trägers (2) zumindest in einem Teilbereich des Gehäuses (10) zugleich die Oberfläche (6) der Innenwandung (4) des Gehäuses (10) bildet.

2. Gehäuse für elektrische oder elektronische Vorrichtungen nach Anspruch 1, **dadurch gekennzeichnet, dass** der flexible Träger (2) separat vorgefertigt ist.

3. Gehäuse für elektrische oder elektronische Vorrichtungen nach einem der Ansprüche 1 oder 2, **dadurch gekennzeichnet, dass** der Träger (2 )einen relativ großen Flächenanteil der Oberfläche der Innenwandung (4) bildet.

4. Gehäuse für elektrische oder elektronische Vorrichtungen nach einem der Ansprüche 1 bis 3, **dadurch gekennzeichnet, dass** die Gehäusewandung (1) eine Dicke von 0,5 bis 4 mm, vorzugsweise von 1,0 bis 2,5 mm hat.

5. Gehäuse für elektrische oder elektronische Vorrichtungen nach einem der Ansprüche 1 bis 4, **dadurch gekennzeichnet, dass** der Träger (2) eine Dicke von 40 bis 250 µm, bevorzugt von 100 bis 150 µm hat.

6. Gehäuse für elektrische oder elektronische Vorrichtungen nach einem der Ansprüche 1 bis 5, **dadurch gekennzeichnet, dass** der Träger (2) aus Polyimid besteht und eine Dicke von 40 bis 250 µm hat.

7. Gehäuse für elektrische oder elektronische Vorrichtungen nach einem der Ansprüche 1 bis 6, **dadurch gekennzeichnet, dass** die innenliegenden Bauteile (3) des flexiblen Trägers (2) von dem Werkstoff der Wandung (1) umschlossen sind.

8. Verfahren zur Herstellung eines Gehäuses nach einem der Ansprüche 1 bis 7, **dadurch gekennzeichnet, dass** auf die Wandung eines geöffneten Spritzwerkzeugs für Kunststoffe ein mit elektronischen Bauteilen (3, 7) bestückter flexibler Träger (2) aufgelegt, das Werkzeug geschlossen, der verflüssigte Kunststoff in das Werkzeug eingespritzt und der Träger (2) durch Verfestigung des Kunststoffes an der Oberfläche des Gehäuses (10) fixiert ist, wonach das Gehäuse (10) aus dem Formraum des Werkzeugs entnommen wird.

9. Verfahren nach Anspruch 8, **dadurch gekennzeichnet, dass** beim Spritzvorgang der verflüssigte Kunststoff gegen die in das Innere des Werkzeugs gerichtete Oberfläche des Trägers (2) gespritzt wird.

10. Verfahren nach einem der Ansprüche 8 oder 9, **dadurch gekennzeichnet, dass** der Träger (2) zu Beginn des Spritzvorgangs durch zumindest einen Niederhalter an die Wandung des Werkzeugs angedrückt wird.

11. Verfahren nach einem der Ansprüche 8 oder 9, **dadurch gekennzeichnet, dass** der Niederhalter während des Spritzvorgangs von dem Träger (2) abgehoben wird.
